# EUROPEAN PATENT APPLICATION

(11) **EP 2 437 309 A1**
(43) Date of publication of application: **04.04.2012**
(21) Application number: 09845288.1
(22) Date of filing: 26.11.2009
(51) Int. Cl.: H01L 31/042

(54) **METHOD FOR MANUFACTURING DYE-SENSITIZED SOLAR CELL**

(30) Priority: 29.05.2009 KR 20090047467
(71) Applicant: SEWON CO., LTD., Wonju-City Kangwon do (KR)
(72) Inventor: KIM, Gang-Beom, Cheonan-si Chungcheongnam-do 330-807 (KR); CHO, Hyun-Seung, Daegu 706-906 (KR); JIN, Chang-Ho, Cheonan-si Chungcheongnam-do 330-090 (KR)
(74) Representative: Serjeants
(86) International application number: PCT/KR2009/007005
(87) International publication number: WO 2010/137781

(57) **Abstract**

The present invention relates to a method of manufacturing a dye-sensitized solar cell having a new structure and, more particularly, to a method of manufacturing a dye-sensitized solar cell using an intermediate having an opening structure of a form in which a specific position between a transparent electrode and a counter electrode laminated is not sealed so that an internal space, formed by the two electrodes and a sealant, communicates with an outside. According to the present invention, there can be provided the method of manufacturing a dye-sensitized solar cell, which has advantages in that a process of manufacturing a solar cell can be shortened and the production cost can be reduced because holes for injecting an electrolyte needs not to be processed in manufacturing the dye-sensitized solar cell and the percent defective due to hole processing can be reduced in manufacturing the solar cell. Furthermore, according to the present invention, the dye-sensitized solar cell having a uniform thickness and surface can be manufactured because there is no change in the thickness of the solar cell which is generated when holes are closed after an electrolyte is injected.

## Description

### BACKGROUND OF THE DISCLOSURE

### 1. Technical Field

The present invention relates to a method of manufacturing a dye-sensitized solar cell, which is capable of reducing a process of manufacturing the dye-sensitized solar cell and the production cost and improving productivity.

### 2. Related Art

The exhaustion of fossil fuel, a sudden rise in price of fossil fuel, and a rapid change in the climate of the earth require sustainable energy acquisition technologies. From among the technologies, solar energy has been in the spotlight in terms of unlimited cleanness and stability.

A conventional silicon solar cell has been widely researched and used industrially, but is problematic in that the price is high and thus economic efficiency is low. Active research is done on a Dye-Sensitized Solar Cell (DSSC) as the next-generation solar cell which has energy conversion efficiency comparable to that of the silicon solar cell and has a low production cost.

In general, the DSSC includes a semiconductor electrode (hereinafter referred to as a "transparent electrode') that nano-particle oxides coated with photosensitive dye molecules are coated on a transparent conductive substrate, an opposite-side electrode (hereinafter referred to as a 'counter electrode') that platinum or carbon is coated on a transparent conductive substrate, and an electrolyte layer filled between the transparent electrode and the counter electrode. Dye molecules generate electron-hole pairs by absorbing solar light.

In general, the conventional DSSC is fabricated as follows.

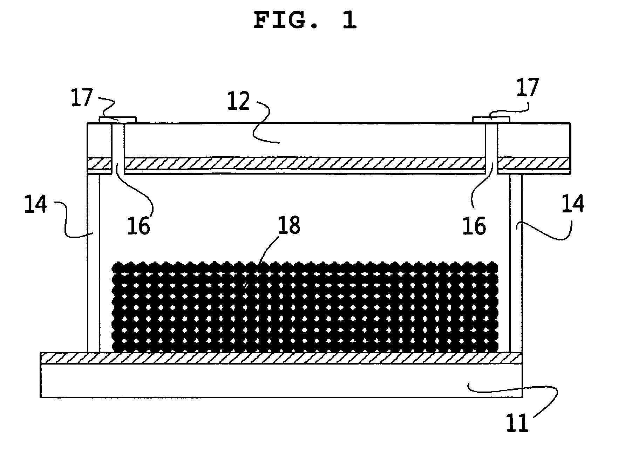

The nano-particle oxides are coated on the transparent electrode substrate, sintered, and then dipped in a photosensitive dye solution so that dyes are absorbed to the coated nano-particle oxides. Holes 16 for injecting an electrolyte are processed in the transparent electrode or the counter electrode. After the two electrodes are laminated and adhered, the electrolyte is injected through the holes 16, and the holes 16 are closed. FIG. 1 is a vertical cross-sectional view of the DSSC fabricated as above.

However, the above electrolyte injection method is problematic in that not only a process of processing the holes is added and thus the production cost is increased, but also the thickness of the solar cell in itself is increased and the surface of the electrode is not uniform owing to hole finishing materials 17, as shown in FIG. 1.

Accordingly, the present invention has been made in view of the above problems occurring in the prior art, and an object of the present invention is to provide a method of manufacturing the DSSC which is capable of reducing a process of manufacturing the DSSC and the production cost of the DSSC.

### SUMMARY OF THE DISCLOSURE

The present invention for solving the object relates to a method of manufacturing a DSSC.

### (1) Intermediate of DSSC

The present invention relates to the intermediate of a DSSC in which a specific position between a transparent electrode and a counter electrode has an opening structure of an unsealed form so that an internal space, formed by the two electrodes and a sealant, communicates with the outside.

If the DSSC is a grid structure, it is preferred that the opening structure be formed in each of both ends of each of grid patterns.

The sealant may be selected from the group consisting of a thermoplastic resin film, thermosetting resin, photo-curable resin, and a glass composition.

### (2) Method of manufacturing a DSSC

Furthermore, the present invention relates to a method of manufacturing a DSSC from the above-described intermediate of a DSSC, comprising the steps of (A) fabricating a pre-transparent electrode by coating nano-particle oxide on a transparent conductive substrate and then sintering the nano-particle oxide; (B) fabricating a counter electrode; (C) fabricating an intermediate of the solar cell having an opening structure having a form in which a specific position between the two electrodes is not sealed so that an internal space, formed by the two electrodes and a sealant, communicates with an outside; (D) adsorbing dye molecules on the nano-particle oxide by injecting a photosensitive dye molecule solution through the opening structure of the intermediate; and (E) injecting an electrolyte through the opening structure and then closing the opening structure. In this method, the adsorption of the dye molecules is performed in the latter half of the process.

For the DSSC with grid structure, it is preferred that the opening structure in step (C) be formed in each of both ends of each of grid patterns.

Furthermore, the present invention relates to a method of manufacturing a dye-sensitized solar cell, comprising the steps of (A) fabricating a pre-transparent electrode by coating nano-particle oxide on a transparent conductive substrate and sintering the nano-particle oxide; (B) adsorbing photosensitive dye molecules on the sintered nano-particle oxide; (C) fabricating a counter electrode; (D) fabricating an intermediate of the solar cell having an opening structure having a form in which a specific position between the two electrodes is not sealed so that an internal space, formed by the two electrodes and a sealant, communicates with an outside; and (E) injecting an electrolyte through the opening structure and then closing the opening structure. For the DSSC with grid structure, it is preferred that the opening structure in step (D) be formed in each of both ends of each of grid patterns. In this method, the adsorption of the dye molecules is performed when the transparent electrode is fabricated in the first half of the process. This method may be used when high temperature processing is not required after the dyes are adsorbed.

At the step (E), the opening structure is closed using a thermoplastic resin film, thermosetting resin, photo-curable resin, or a glass composition.

As described above, according to the present invention, there can be provided the method of manufacturing a DSSC having a new structure, which has an advantage in that a process of manufacturing a solar cell can be shortened and the production cost can be reduced because holes for injecting an electrolyte needs not to be processed in manufacturing the DSSC and the percent defective due to hole processing can be reduced in manufacturing the solar cell. Furthermore, according to the present invention, the DSSC having a uniform thickness and surface can be manufactured because there is no change in the thickness of the solar cell which is generated when holes are closed after an electrolyte is injected.

### BRIEF DESCRIPTION OF THE DRAWINGS

FIG. 1 is a vertical cross-sectional view of a conventional DSSC in which holes for injecting an electrolyte are formed.
FIG. 2 is a diagram showing an example of a DSSC intermediate according to the present invention.
FIG. 3 is a perspective view showing an example of the intermediate in which a metal grid is formed in the conductive substrate of the DSSC.
FIG. 4 is a diagram showing an example of an apparatus for injecting dye molecules into the opening structure of the DSSC intermediate according to the present invention.

### DETAILED DESCRIPTION OF EMBODIMENTS

The present invention is described in detail with reference to the accompanying drawings. The drawings and the description, however, are only illustrative in order to easily describe the contents and scope of the technical spirit of the present invention, but the technical scope of the present invention is not limited or changed by the drawings and the description. Furthermore, it would be evident to a person having ordinary skill in the art that a variety of modifications and changes are possible within the scope of the technical spirit of the present invention on the basis of the illustration.

The present invention does not relate to detailed components forming a DSSC, and thus a type of a substrate, a type and characteristic of nano-particle oxide, a type and characteristic of photosensitive dyes, the structure of a counter electrode in itself, a formular and type of an electrolyte and so on will not be described in detail.

In the present invention, a 'pre-transparent electrode' refers to a transparent electrode before photosensitive dye molecules are adsorbed on nano-particle oxide.

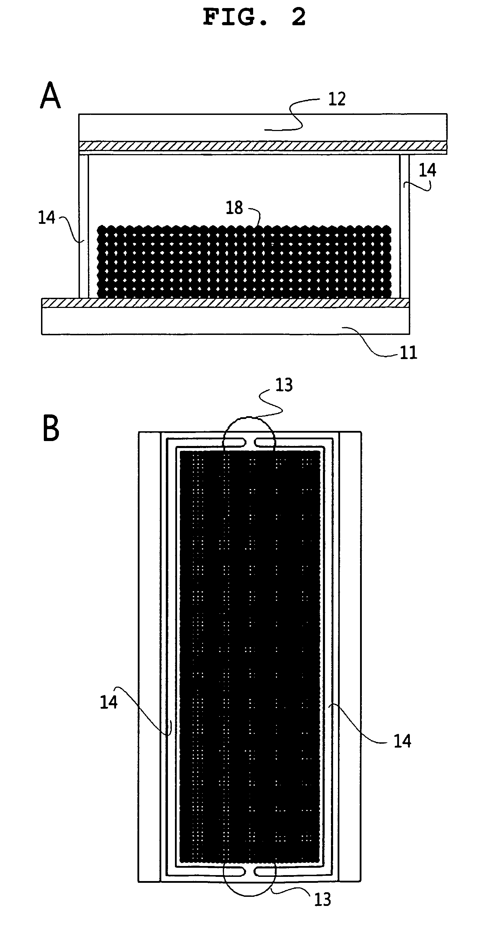

FIG. 2 is a diagram showing an example of the intermediate of a DSSC having opening structures 13 in each of which a specific position between a transparent electrode 11 and a counter electrode 12, laminated according to the present invention, is not sealed so that an internal space, formed by the two electrodes and a sealant 14, communicates with the outside. (A) is a vertical cross-sectional view of an intermediate, and (B) is a horizontal cross-sectional view of the intermediate.

As shown in FIG. 2(B), the intermediate of a DSSC according to the present invention has the opening structures 13 which are formed by not coating the sealant 14 on specific positions in a process of coalescing the transparent electrode 11 and the counter electrode 12 with the sealant 14. A dye solution or an electrolyte is injected through the opening structures 13. As can be seen from FIG. 2(A), the DSSC intermediate according to the present invention has a uniform electrode surface without a phenomenon in which the surface of the electrode substrate is projected by the hole finishing materials.

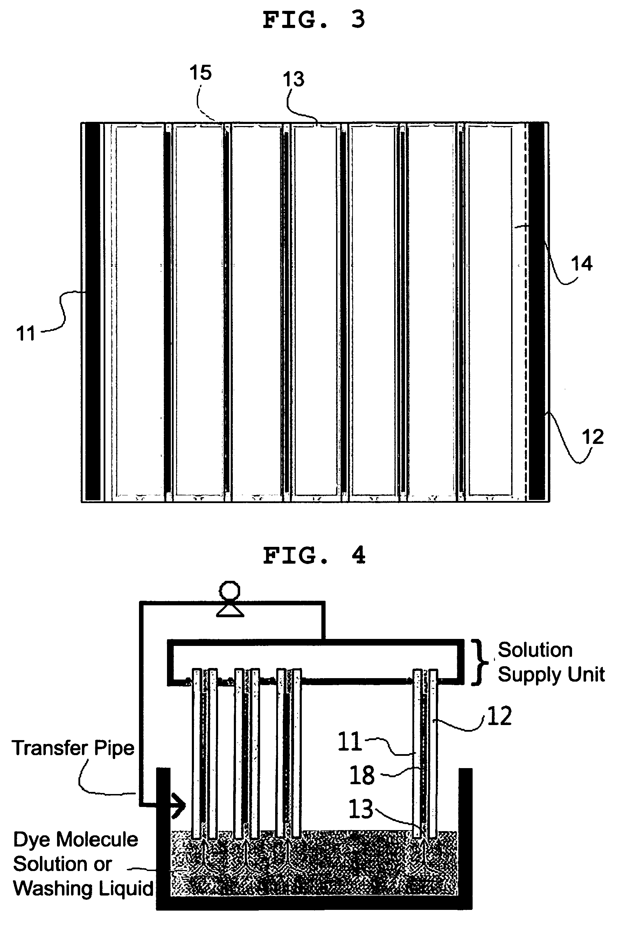

Meanwhile, in order to lower electrical resistance of the transparent conductive substrate, the intermediate according to the present invention may be used even in a lattice type (or grid type) DSSC having a serial structure or a parallel structure, wherein a metal grid is formed on the transparent conductive substrate or a metal grid 15 is formed on the substrate and a thin transparent conductive film is coated thereon (FIG. 3). Here, as shown in FIG. 3, it is preferred that the opening structures 13 be formed at both ends of each of grid patterns. The present invention is not related to the structure in itself the lattice type or the grid type DSSC, and a detailed description of the structure is omitted.

In the intermediate of the DSSC according to the present invention, a variety of materials (that is, a thermoplastic resin film, thermosetting resin, photo-curable resin, or a glass composition) used to adhere the two electrodes to each other in the conventional process of manufacturing a DSSC may be used as the sealant 14 that determines the internal space along with the transparent electrode 11 and the counter electrode 12.

From among, if the glass composition is used, there is an advantage in that the durability and long-term stability of the DSSC can be greatly improved. However, it is better to use an unleaded glass-based composition because a glass composition including lead (Pb), from the glass compositions, has a bad influence on the counter electrode 12 in a thermal treatment process, thereby lowering cell efficiency. There was filed a Korean Patent Application No. 10-2009-14755 in relation to the method of manufacturing a DSSC using an unleaded-based glass composition.

A method of manufacturing a DSSC according to the present invention chiefly includes 'the step of fabricating the transparent electrode → the step of fabricating the counter electrode → the step of fabricating the intermediate of the DSSC → the step of injecting the electrolyte the step of closing the opening structures of the intermediate'. There are two types of different manufacturing methods according to a point of time when dye molecules are adsorbed.

### ① Adsorption is performed before the intermediate of the DSSC is fabricated

After the pre-transparent electrode is fabricated, the photosensitive dye molecules are adsorbed on nano-particle oxide according to a common method.

In other words, in this case, the method of manufacturing a DSSC includes the steps of (A) fabricating a pre-transparent electrode by coating nano-particle oxide 18 on the transparent conductive substrate and then sintering the nano-particle oxide; (B) adsorbing photosensitive dye molecules on the sintered nano-particle oxide 18; (C) fabricating the counter electrode; (D) fabricating the intermediate of the solar cell having the opening structures using the two electrode substrates and the sealant; and (E) injecting an electrolyte through the opening structures and then closing the opening structures. Here, it is preferred that the step (D) of fabricating the intermediate of the solar cell be performed using laser processing.

### ② If adsorption is performed after the intermediate of the DSSC is fabricated

Furthermore, dye molecules may be adsorbed on the nano-particle oxide by injecting a photosensitive dye molecule solution before the electrolyte is injected through the opening structures of the intermediate after the intermediate of the DSSC is fabricated.

In other words, in this case, the method of manufacturing a DSSC includes the steps of (A) fabricating the pre-transparent electrode by coating the nano-particle oxide 18 on the transparent conductive substrate and then sintering the nano-particle oxide; (B) fabricating the counter electrode; (C) fabricating the intermediate of the solar cell having the opening structures using the two electrode substrates and the sealant; (D) adsorbing dye molecules on the nano-particle oxide 18 by injecting the photosensitive dye molecule solution through the opening structures of the intermediate; and (E) injecting an electrolyte through the opening structures and then closing the opening structures.

The opening structure of the DSSC intermediate according to the present invention has a very narrow structure. Accordingly, if the dye molecules are adsorbed in such a way that the dye solution flows into the internal space of the intermediate through the opening structures by dipping the intermediate of the solar cell in the dye solution using a common method (that is, as in the ①) at the step (D), the dye solution does not easily flow into the internal space and the dye molecules are difficult to be uniformly adsorbed.

For this reason, it is preferred that the method of injecting the photosensitive dye molecule solution through the opening structures at the step (D) consists of, more particularly, (i) adsorbing the dye molecules on the nano-particle oxide coated on the transparent conductive substrate by making the photosensitive dye molecule solution flow into the internal space through the opening structures; and (ii) after the dye molecules are adsorbed, removing dye molecules not adsorbed by making washing liquid flow into the inside of the coalesced substrates through the opening portions on both sides. FIG. 4 is a diagram showing an apparatus for injecting the dye molecules using the method.

The dye molecule solution may be made to flow from the top to the bottom, from the bottom to the top, or horizontally using a pump or a vacuum decompression method. Here, in order to prevent the waste of the dye molecule solution and improve work efficiency, it is better to circulate the photosensitive dye molecule solution. Furthermore, if the photosensitive dye molecule solution is repeatedly circulated, it is preferred that a concentration of the dye molecules be regularly controlled.

Meanwhile, after the dye molecules not adsorbed are removed, it is preferred that wash liquid be evaporated by circulating hot dry air around the internal space via the opening structures so that the wash liquid is rapidly removed

It is preferred that the above method be used as the method of injecting the electrolyte into the internal space of the intermediate of the solar cell through the opening structures.

The present applicant filed a Korean Patent Application No. 10-2009-21406 (2009.3.13) in relation to the method of injecting the dye solution and the electrolyte into the internal space of the solar cell which is formed by the two electrodes and the sealant.

According to the method, after the counter electrode and the pre-transparent electrode to which the dye molecules are not adsorbed are sealed by the sealant, the photosensitive dye molecules are adsorbed. Accordingly, since thermal processing in the steps before the dye molecules are adsorbed has nothing influence on the performance of the solar cell, a person having ordinary skill in the art may perform a process until the intermediate of the DSSC is fabricated by adequately selecting thermal processing or laser processing for the sake of convenience.

Accordingly, a whole DSSC in which the dye molecules are not decomposed is obtained.

### [Industrial Applicability]

According to the method of manufacturing a DSSC according to the present invention, there are advantages in that a process of manufacturing a solar cell can be shortened, the production cost can be reduced, productivity can be improved, and the percent defective due to hole processing can be reduced in manufacturing the solar cell. Furthermore, a DSSC having a uniform thickness and surface can be fabricated because there is change in the thickness of the solar cell when holes are finished after an electrolyte is injected.

## Claims

1. A method of manufacturing a dye-sensitized solar cell, comprising the steps of:
(A) fabricating a pre-transparent electrode by coating nano-particle oxide on a transparent conductive substrate and then sintering the nano-particle oxide;
(B) fabricating a counter electrode;
(C) fabricating an intermediate of the solar cell having an opening structure having a form in which a specific position between the two electrodes is not sealed so that an internal space, formed by the two electrodes and a sealant, communicates with an outside;
(D) adsorbing dye molecules on the nano-particle oxide by injecting a photosensitive dye molecule solution through the opening structure of the intermediate; and
(E) injecting an electrolyte through the opening structure and then closing the opening structure.

2. The method according to claim 1, wherein if a metal grid is formed in the transparent conductive substrate of the dye-sensitized solar cell, the opening structure is formed at both ends of each of grid patterns.

3. The method according to claim 1 or 2, wherein at the step (E), the opening structure is closed by using any one selected from a group consisting of a thermoplastic resin film, thermosetting resin, photo-curable resin, and a glass composition.

4. A method of manufacturing a dye-sensitized solar cell, comprising the steps of:
(A) fabricating a pre-transparent electrode by coating nano-particle oxide on a transparent conductive substrate and sintering the nano-particle oxide;
(B) adsorbing photosensitive dye molecules on the sintered nano-particle oxide;
(C) fabricating a counter electrode;
(D) fabricating an intermediate of the solar cell having an opening structure having a form in which a specific position between the two electrodes is not sealed so that an internal space, formed by the two electrodes and a sealant, communicates with an outside; and
(E) injecting an electrolyte through the opening structure and then closing the opening structure.

5. The method according to claim 5, wherein if a structure in which a metal grid is formed is formed in the transparent conductive substrate of the dye-sensitized solar cell, the opening structure is formed at both ends of each of grid patterns.

6. The method according to claim 5 or 6, wherein at the step (E), the opening structure is closed by using any one selected from a group consisting of a thermoplastic resin film, thermosetting resin, photo-curable resin, and a glass composition.
